# EUROPÄISCHE PATENTSCHRIFT

(11) **EP 2 510 371 B1**
(45) Veröffentlichungstag und Bekanntmachung des Hinweises auf die Patenterteilung: **26.06.2013**
(21) Anmeldenummer: 10773282.8
(22) Anmeldetag: 22.10.2010
(51) Int. Cl.: G01R 33/04, G01R 33/05

(54) **MAGNETFELDSENSOR**
MAGNETIC FIELD SENSOR
CAPTEUR MAGNÉTIQUE

(30) Priorität: 08.12.2009 DE 102009047624
(43) Veröffentlichungstag der Anmeldung: 17.10.2012
(73) Patentinhaber: Robert Bosch GmbH, 70442 Stuttgart (DE)
(72) Erfinder: PATAK, Christian, 72762 Reutlingen (DE); WEISS, Stefan, 72070 Tuebingen (DE); NJIKAM NJIMONZIE, Frederic, 72762 Reutlingen (DE); SCHATZ, Frank, 70806 Kornwestheim (DE); FARBER, Paul, 70193 Stuttgart (DE); BIERHOFF, Christian, 72762 Reutlingen (DE)
(86) Internationale Anmeldenummer: PCT/EP2010/065922
(87) Internationale Veröffentlichungsnummer: WO 2011/069738

(56) Entgegenhaltungen:
- JP-A- 9 318 720
- US-A1- 2007 222 441
- US-B1- 6 404 192

## Beschreibung

### Stand der Technik

Zur Messung von Magnetfeldern sind Fluxgate-Sensoren bekannt. In einer Variante solcher Fluxgate-Sensoren wird ein weichmagnetischer Kern einem magnetischen Wechselfeld ausgesetzt, das den Kern mit wechselnden Feldrichtungen in die magnetische Sättigung treibt. Eine Ummagnetisierung des Kerns findet immer dann statt, wenn das magnetische Wechselfeld ein externes magnetisches Feld gerade kompensiert. Auf der Basis eines Zeitpunktes der Ummagnetisierung in Bezug auf das generierte magnetische Wechselfeld kann das externe magnetische Feld bestimmt werden. Derartige Sensoren können als Dünschicht-Technologie auf einem Halbleiter-Substrat hergestellt werden, oft auch als MEMS-Sensor bezeichnet.

Die nicht veröffentlichte Patentanmeldung DE 10 2009 028 815.5 zeigt einen Magnetfeldsensor in MEMS-Technologie, bei dem eine Spule ein Magnetfeld in einem quaderförmigen Kern erzeugt. Auch US6404192, US2007/0222 441 und JP09318720 offenbaren Fluxgate-Sensoren.

Der Erfindung liegt die Aufgabe zugrunde, einen Magnetfeldsensor anzugeben, mittels dem der Zeitpunkt der Ummagnetisierung genauer bestimmt werden kann.

### Offenbarung der Erfindung

Die Erfindung löst das angegebene Problem durch einen Magnetfeldsensor mit den Merkmalen von Anspruch 1. Unteransprüche geben vorteilhafte Ausgestaltungsmöglichkeiten an.

Ein Magnetfeldsensor umfasst einen magnetisierbaren Kern, eine Magnetisierungseinrichtung zum Magnetisieren des Kerns und eine Bestimmungseinrichtung zum Bestimmen eines magnetischen Feldes im Kern, wobei der Kern eine wenigstens abschnittweise gekrümmte Oberfläche hat. Insbesondere bei einem miniaturisierten Magnetfeldsensor (MEMS) kann durch die Krümmung der Oberfläche des Kerns ein Auftreten schlecht magnetisierbarer Bereiche vermieden werden, so dass magnetische Domänen des Kerns keine stark unterschiedlichen Felder zum Ummagnetisieren erfordern. Somit kann eine statistische Schwankung des Ummagnetisierungszeitpunkts reduziert und dadurch eine Messgenauigkeit des Magnetfeldsensors verbessert werden.

Der Kern kann einen Längsschnitt mit positiver Krümmung aufweisen. Dabei kann die Krümmung entlang des gesamten Längsschnitts positiv sein. Insbesondere kann die Krümmung entlang des Längsschnitts einen vorbestimmten Wert nicht übersteigen. Damit ergibt sich ein Kern mit abgerundeten Konturen, so dass schlecht magnetisierbare Domänen weiter reduziert werden können.

Der Kern kann achsensymmetrisch zu seiner Längsachse ausgebildet sein. Im Gegensatz zu einer flachen Ausführungsform können auf diese Weise weitere Ecken und Kanten des Kerns vermieden werden, so dass die Magnetisierbarkeit der Domänen des Kerns gleichförmiger wird. Dies kann zu weiter verbesserten Magnetfeldbestimmungen führen.

Der Kern kann einen angespitzten bzw. kegelförmigen Endabschnitt aufweisen. Durch ein damit verbundenes Reduzieren bzw. Vermeiden von Abschlussdomänen kann die Ummagnetisierung auf einen noch engeren zeitlichen Bereich verlagert werden, sodass die Messgenauigkeit des Magnetfeldsensors weiter gesteigert werden kann.

Ferner kann der Kern unsymmetrisch geformt sein, beispielsweise indem ein geometrischer Schwerpunkt des Kerns entlang der Längsachse des Kerns durch Verzerren der äußeren Abmessungen des Kerns in Richtung eines Endabschnitts verlagert ist. Dies kann beispielsweise durch eine im Wesentlichen trapezförmige Ausführung des Kerns erzielt werden. Dadurch kann ein Beginn eines Ummagnetisierungsvorgangs des Kerns besser definiert sein, wodurch eine zeitliche Reproduzierbarkeit der Ummagnetisierung des Kerns weiter verbessert sein kann.

In weiteren Ausführungsformen kann der Kern entlang seiner Längsachse mehrere Abschnitte mit unterschiedlich großen Längsschnittsflächen aufweisen, so dass Bereiche definierter Magnetisierung zum Starten des Ummagnetisierungsprozesses bestimmt sind.

### Kurze Beschreibung der Figuren

Im Folgenden wird die Erfindung mit Bezug auf die beiliegenden Figuren genauer beschrieben, in denen:
- Figur 1: ein Prinzipbild eines Fluxgate-Magnetfeldsensors;
- Figur 2: zeitliche Abläufe am Magnetfeldsensor von Figur 1; und
- Figur 3: Ansichten verschiedener Kerne für den Magnetfeldsensor von Figur 1
zeigen.

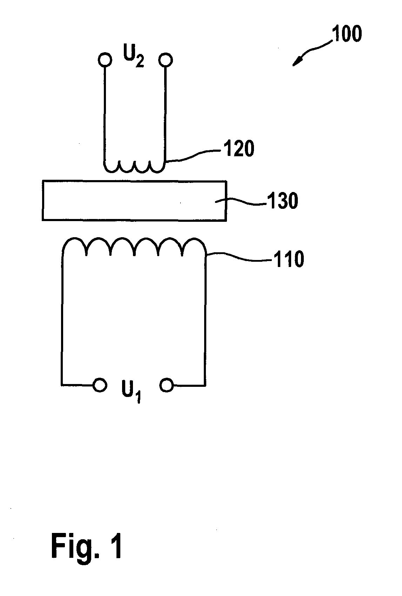

Figur 1 zeigt ein Prinzipbild eines Magnetfeldsensors 100. Der Magnetfeldsensor 100 umfasst eine erste Spule 110, eine zweite Spule 120 und einen Kern 130. Der Magnetfeldsensor 100 ist als Dünnschicht-System aufgebaut. Dabei ist der Kern 130 in einem Ausführungsbeispiel eines miniaturisierten (MEMS) Magnetfeldsensors 100 einige 100µm bis einige mm lang und weist eine Breite von typischerweise 20 bis 200 µm auf. Die erste Spule 110 und die zweite Spule 120 können jeweils eine oder mehrere Windungen umfassen und jede der Windungen kann auf einem Substrat des Magnetfeldsensors 100 ausgebildet sein. Dabei können die Windungen den Kern 130 umschließen oder neben dem Kern 130 verlaufen. Mittels der zweiten Spule 120 kann ein Hinweis auf das Magnetfeld im Kern 130 bestimmt werden, beispielsweise eine magnetische Flussdichte oder ein magnetischer Fluss.

An die erste Spule 110 wird ein periodischer (z.B. dreieckiger) Spannungsverlauf angelegt, so dass im Bereich des Kerns 130 ein Magnetfeld erzeugt wird, das periodisch ab- und zunimmt. Der Kern 130 besteht vorzugsweise aus einem weichmagnetischen Material mit einer geringen Hysterese..

Durch das magnetische Wechselfeld, welches durch die erste Spule 110 hervorgerufen wird, erfährt der Kern 130 periodisch Ummagnetisierungen, wenn sich eine Richtung der Magnetisierung des Kerns 130 ändert. Zu Zeitpunkten der Ummagnetisierungen wird in der zweiten Spule 120 ("Pick-Up-Spule") eine Spannung U2 induziert. Auf der Basis eines Zeitpunktes eines solchen Spannungsimpulses 220 kann, wie unten weiter ausgeführt ist, ein externes Magnetfeld bestimmt werden. Um den Zeitpunkt des Impulses möglichst genau zu messen, muss der Impuls bezüglich einer Periode der Dreiecksspannung U1 möglichst schmal sein. Zu diesem Zweck wird üblicherweise ein Material des Kerns 130 derart gewählt, dass die Hysterese des Kerns 130 möglichst klein ist.

Für miniaturisierte Fluxgate-Magnetfeldsensoren sind der Optimierung der Kleinheit der Hysterese des Kerns 130 durch entsprechende Wahl von Material und Herstellungsprozess des Kerns 130 im Rahmen eines Herstellungsprozesses eines miniaturisierten Systems Grenzen gesetzt. Zudem sinkt mit fortschreitender Miniaturisierung der Spulen 110, 120 und des Kerns 130 die Stärke des Impulses 220, so dass eine Auswertung der Signalspannung U2 erschwert ist.

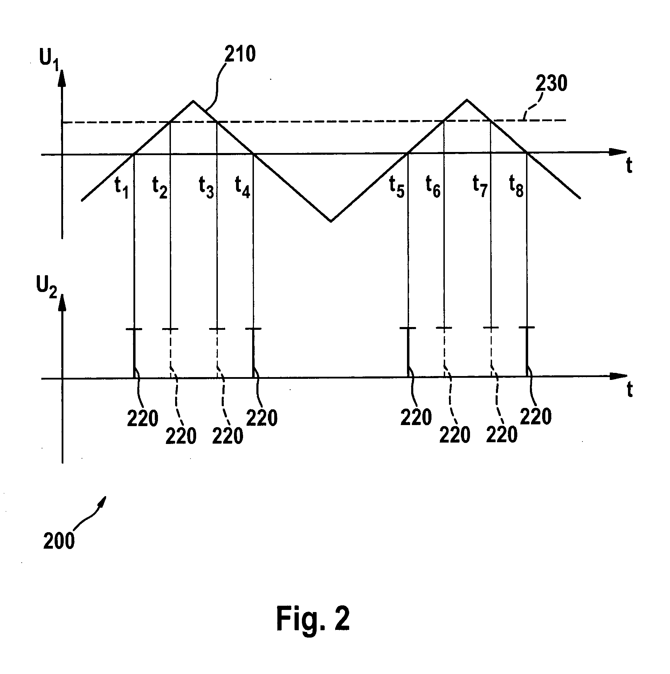

Figur 2 zeigt ein Diagramm 200 zeitlicher Verläufe der Spannungen U1 und U2 am Magnetfeldsensor 100 aus Figur 1. Ein im oberen Teil des Diagramms 200 dargestellter Verlauf 210 repräsentiert einen Verlauf der Spannung U1 an der ersten Spule 110 in Figur 1. Im unteren Teil des Diagramms 200 dargestellte Impulse 220 entsprechen Spannungsimpulsen von U2 an der zweiten Spule 120 in Figur 1.

Der Verlauf 210 ist ein symmetrisches Dreieckssignal. Eine Magnetisierung des Kerns 130 ist proportional zum Verlauf 210. Zu den Zeitpunkten t1, t4, t5 und t8 hat die Spannung U1 des Verlaufs 210 den Wert 0. Liegt kein externes Magnetfeld an, so erfolgt zu diesen Zeitpunkten eine Ummagnetisierung des Kerns 130 in Figur 1, was durch Impulse 220 der Spannung U2 der Spule 120 in Figur 1 zu denselben Zeitpunkten erfassbar ist.

Ist der Kern 130 durch ein externes Magnetfeld vormagnetisiert, erfolgen Ummagnetisierungen des Kerns 130 jeweils zu Zeitpunkten, wenn das externe Magnetfeld durch das mittels der ersten Spule 110 hervorgerufene Magnetfeld kompensiert wird. In der Darstellung von Figur 2 ist das immer dann der Fall, wenn der erste Verlauf 210 der externen Magnetisierung 230 entspricht, also zu den Zeitpunkten t2, t3, t6 und t7.

Aus einer relativen Lage der Impulse 220 zueinander bzw. zum Verlauf 210 können Stärke bzw. Richtung des externen Magnetfelds bestimmt werden. Um eine Messung der Impulse 220 bzw. der Zeitpunkte t1 bis t8 möglichst genau durchführen zu können, ist es erforderlich, dass die Impulse 220 der Spannung U2 eine vorbestimmte Spannung erreichen und dabei so schmal wie möglich sind.

Ein ferromagnetischer Stoff wie der Kern 130 weist üblicherweise eine Kristallstruktur mit magnetisierten Domänen auf. Diese Domänen werden Weiss-Bezirke genannt und haben eine Ausdehnung im Bereich von ca. 10⁻⁸ bis 10⁻⁴ m.
Die Grenzen zwischen den Weiss-Bezirken heißen Bloch-Wände. Allgemein sind die Weiss-Bezirke bis zur Sättigung magnetisiert, wobei die Magnetisierung unterschiedlicher Weiss-Bezirke unterschiedliche Richtungen aufweist. In einem ansteigenden Magnetfeld verschieben sich die Bloch-Wände zugunsten derjenigen Weiss-Bezirke, die in Richtung des äußeren Feldes ausgerichtet sind. Bei weiter ansteigendem äußeren Feld ändern schließlich immer mehr Weiss-Bezirke ihre magnetische Ausrichtung.

Die Verschiebungsbewegung der Bloch-Wände können von Gitterfehlern im Kristall des ferromagnetischen Stoffs, Korngrenzen oder einer Begrenzung des magnetischen Stoffs selbst in ihrer Bewegung gehindert werden. Dieser Effekt wird "Pinning" genannt. Effektiv steigt die Magnetisierung des ferromagnetischen Stoffs somit nicht dem extern stetig ansteigenden Magnetfeld folgend, sondern in kleinen Differenzen, den Barkhausen-Sprüngen. Dadurch wird eine gleichmäßige Ummagnetisierung des ferromagnetischen Stoffs verhindert, so dass im Fall des Kern 130 in Figur 1 die Impulse 220 aus Figur 2 eine Aufweitung in zeitlicher (horizontaler) Richtung erfahren. Der Kern der Erfindung besteht darin, den Kern 130 derart zu formen, dass eine möglichst homogene und schnelle Ummagnetisierung des Kerns 130 in einem miniaturisierten Magnetsensor 100 ermöglicht ist. Zu diesem Zweck sind die Begrenzungen des Kerns 130 derart ausgebildet, dass Pinning-Effekte vermindert werden. Zudem kann der Kern 130 derart geformt sein, dass ein Ummagnetisierungsprozess durch die Form des Kerns 130 beeinflusst ist.

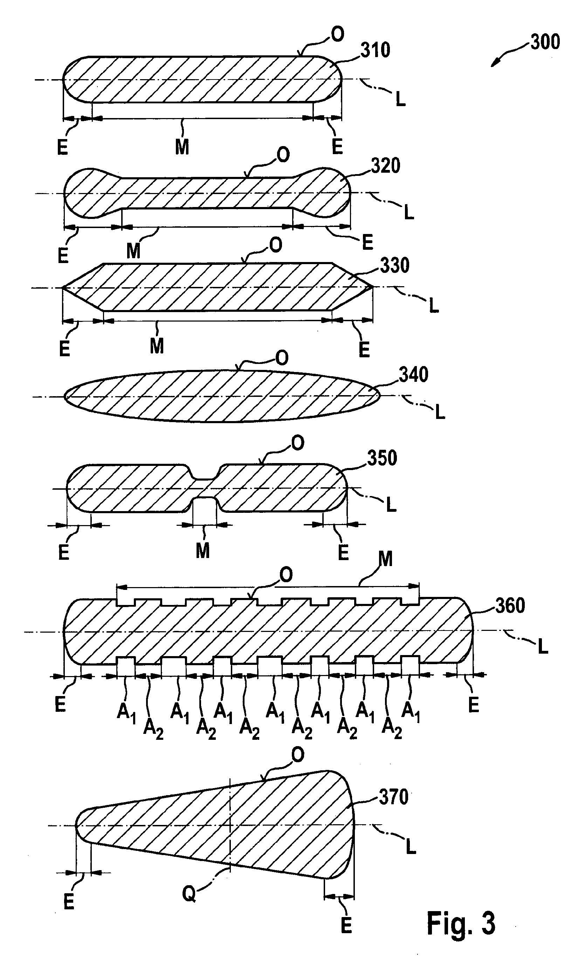

Figur 3 zeigt Längsschnitte verschiedener Kerne 130 für den Magnetfeldsensor 100 aus Figur 1. Die dargestellten Längsschnitte 310 bis 370 können jeweils einen Kern 130 betreffen, der im Wesentlichen flach ist, so dass der Längsschnitt 310 bis 370 einer Draufsicht auf den Kern 130 entspricht. Solche Kerne können bevorzugt in Dünnschicht-Technologie hergestellt werden.

In einer Variante ist der Kern 130 beispielsweise bezüglich einer Längsachse L des Kerns 130 achsensymmetrisch ausgeführt, sodass sich die dreidimensionale Form des Kerns 130 jeweils durch Rotation der Längsschnitte 310 bis 370 um deren Längsachsen definieren lässt, und der betreffende Kern ausschließlich kreisförmige Querschnitte aufweist. Zwischenformen zwischen einer flachen und einer runden Ausformung, etwa mit abgeflachten bzw. ellipsenförmigen Querschnitten, sind ebenfalls möglich. Zur Herstellung solcher Kerne kann eine andere Herstellungsweise als mittels Dünnschicht-Technologie erforderlich sein.

Die Längsschnitte 310 bis 370 weisen jeweils Abschnitte auf, an denen eine Oberfläche O des Kerns 130 gekrümmt ist. In diesen Abschnitten wird eine Wanderung von Bloch-Wänden durch eine Begrenzung des Kerns 130 in vermindertem Maße behindert. Bei allen Längsschnitten 310 bis 370 ist ein Verhältnis zwischen Länge und Breite des jeweiligen Längsschnitts so gewählt, dass die Bewegung der Bloch-Wände möglichst wenig gestört wird. Ein derart geformter Kern 130 ist in der Literatur bekannt als "schmaler Kern".

Der erste Längsschnitt 310 weist die Form eines Rechtecks mit abgerundeten Endabschnitten E auf. Abrundungen der Endabschnitte E können jeweils paarweise ineinander übergehen, so dass die Endabschnitte E die Form von Halbkreisen oder Ellipsenabschnitten aufweisen.

Der zweite Längsschnitt 320 entspricht dem ersten Längsschnitt 310, ist jedoch zusätzlich in einem mittleren Abschnitt M zwischen den Enden verjüngt. Übergänge zwischen den Endabschnitten E und dem verjüngten Abschnitt M verlaufen vorzugsweise abgerundet. Durch den verjüngten Abschnitt M kann die zum sprunghaften Magnetisieren des Kerns 130 erforderliche Feldstärke über die Form des Kerns 130 gesteuert werden. Im Bereich des verjüngten Abschnitts M liegt eine erhöhte magnetische Flussdichte vor, die eine schnelle Ummagnetisierung des Abschnitts M fördert. Die verdickten Endabschnitte E führen bei gleicher elektrischer Signalform 210 in Figur 2 zu kleineren Magnetfeldern, was Vorteile im Bauteil bezüglich Messbereich und Ausrichtung bietet. Durch diesen Effekt wird auch die zeitliche Reproduzierbarkeit der Impulse 220 in Figur 2 verbessert und damit das Rauschen des miniaturisierten Magnetfeldsensors 100 aus Figur 1 verringert.

Der dritte Längsschnitt 330 umfasst einen rechteckigen Mittenbereich M, der in zwei jeweils dreieckige Endabschnitte E übergeht. Die spitze Form der dreieckigen Endabschnitte E vermeidet eine schlechte Magnetisierung in diesen Bereichen und bietet zudem einer sich durch den Kern 130 verschiebenden Bloch-Wand einen Start- bzw. Endpunkt. Durch das Fehlen von Abschlussdomänen kann das gesamte Material des Kerns 130 im Längsschnitt 330 zum Signal 220 beitragen.

Der vierte Längsschnitt 340 weist die Form einer symmetrischen Ellipse auf. Bezüglich der Vorteile dieses Längsschnitts gilt das oben bezüglich des dritten Längsschnitts 330 Ausgeführte. Zusätzlich wird durch die elliptische Form des Längsschnitts 340 ein Vorliegen von für ein externes Magnetfeld schlecht zugänglichen Bereichen vermieden.

Der fünfte Längsschnitt 350 entspricht dem ersten Längsschnitt 310 mit einer starken Verengung in einem mittleren Abschnitt M. Diese starke Verengung führt zu einer extremen Flussdichteüberhöhung in diesem Bereich, die sofort zur Ummagnetisierung angrenzender Bereiche führt.

Der sechste Längsschnitt 360 geht aus der Grundform des ersten Längsschnitts 310 hervor und weist noch flacher abgerundete Endabschnitte E sowie einen segmentierten Mittenbereich M auf. Im segmentierten Mittenbereich M wechseln sich Segmente A1 einer ersten Breite mit Segmenten A2 einer zweiten Breite (in horizontaler Richtung) ab. Übergänge zwischen benachbarten Segmenten A1, A2 können wie dargestellt rechteckig oder auch abgerundet, wie beim Mittenbereich M des fünften Längsschnitts 350 gezeigt ist, verlaufen. Durch den gezackten Rand des Längsschnitts 360 wird ein Pinning von Bloch-Wänden reduziert und gleichzeitig werden Bereiche definierter Magnetisierung zum Starten des Ummagnetisierungsprozesses geboten. Ein Verhältnis von Breiten benachbarter Segmente A1, A2 kann beliebig gewählt sein und muss nicht das dargestellte Verhältnis von 1:1 aufweisen.

Der siebte Längsschnitt 370 geht aus einer trapezförmigen Verzerrung des ersten Längsschnitts 310 hervor. Die Verzerrung bildet ein Rechteck in ein Trapez ab, wobei die Grundlinie des Trapezes parallel zur Längsachse L des Kerns 130 verlaufen kann oder senkrecht zur Längsachse L, wie beim Kern 370. Durch die definierte Unsymmetrie des Längsschnitts 370 kann ein besser definierter Start des Ummagnetisierungsvorgangs und damit eine verbesserte zeitliche Reproduzierbarkeit der Impulse 220 aus Figur 2 erzielt werden. Ein Flächenschwerpunkt des Kerns 130 liegt beim siebten Längsschnitt rechts von einer Querachse Q, welche die Längsachse L im Kern 130 halbiert. Die definierte Unsymmetrie des siebten Längsschnitts 370 lässt sich grundsätzlich auf jeden der Längsschnitte 310 bis 360 anwenden und kann durch entsprechende Verzerrungen realisiert werden.

Durch die mit den Längsschnitten 310 bis 370 gezeigte Ausformung des Kerns 130, insbesondere durch Vorsehen von abgerundeten Abschnitten, wird ein zeitlich genau definiertes und zügiges Ummagnetisieren des Kerns 130 im miniaturisierten System 100 aus Figur 1 verbessert. Effektiv lässt sich durch die erfindungsgemäße Ausformung des Kerns 130 eine Messgenauigkeit des Magnetfeldsensors 100 verbessern. Dabei können zusätzlich weitere Maßnahmen, wie beispielsweise einer Wahl eines Materials oder eines Fertigungsprozesses für den Kern 130 bzw. den Magnetfeldsensor 100 für eine weitere Optimierung der Ummagnetisierung des Kerns 130 verwendet werden.

## Patentansprüche

1. Magnetfeldsensor (100) mit
- einem magnetisierbaren Kern (130);
- einer Magnetisierungseinrichtung (110) zum Magnetisieren des Kerns (130), und
- einer Bestimmungseinrichtung (120) zum Bestimmen eines magnetischen Feldes im Kern (130),
wobei der Kern (130) eine wenigstens abschnittweise gekrümmte Oberfläche (O) hat,
**dadurch gekennzeichnet dass**
der Kern zwei Enden aufweist, wobei sich der Kern in einem mittleren Abschnitt (M, Q) zwischen den Enden verjüngt.

2. Magnetfeldsensor (100) nach Anspruch 1, **dadurch gekennzeichnet, dass** der Längsschnitt (320, 350) des Kerns Enden mit verdickten Endabschnitten (E) aufweist.

3. Magnetfeldsensor (100) nach Anspruch 1 oder 2, **dadurch gekennzeichnet, dass** der Längsschnitt (350) des Kerns im mittleren Abschnitt (M) eine starke Verengung aufweist,

4. Magnetfeldsensor (100) nach Anspruch 1, **dadurch gekennzeichnet, dass** der Längsschnitt (360) des Kerns einen segmentierten mittleren Abschnitt (M) aufweist, wobei
- sich bei der Segmentierung Segmente einer ersten Breite (A1) mit Segmenten einer zweiten Breite (A2) in horizontaler Richtung abwechseln und
- die Segmente der ersten Breite (A1) eine Verjüngung aufweisen.

5. Magnetfeldsensor (100) nach einem der Ansprüche 1 bis 4 **dadurch gekennzeichnet, dass** der Kern (130) eine Längsachse (L) aufweist, zu der er achsensymmetrisch ausgebildet ist.

6. Magnetfeldsensor (100) nach einem der vorangehenden Ansprüche, **dadurch gekennzeichnet, dass** die Oberfläche (O) des Kerns (130) in einem Übergangsbereich zwischen den Abschnitten (M, E, A1, A2) gekrümmt ist.

## Claims

1. Magnetic field sensor (100) comprising
- a magnetizable core (130);
- a magnetization device (110) for magnetizing the core (130), and
- a determination device (120) for determining a magnetic field in the core (130),
wherein the core (130) has an at least sectionally curved surface (O), **characterized in that** the core has two ends, wherein the core is tapered in a central section (M, Q) between the ends.

2. Magnetic field sensor (100) according to Claim 1, **characterized in that** the longitudinal section (320, 350) through the core has ends with widened end sections (E).

3. Magnetic field sensor (100) according to Claim 1 or 2, **characterized in that** the longitudinal section (350) through the core has a significantly narrowed portion in the central section (M).

4. Magnetic field sensor (100) according to Claim 1, **characterized in that** the longitudinal section (360) through the core has a segmented central section (M), wherein
- with the segmentation, segments of a first width (A1) alternate with segments of a second width (A2) in the horizontal direction, and
- the segments of the first width (A1) have a tapered portion.

5. Magnetic field sensor (100) according to one of Claims 1 to 4, **characterized in that** the core (130) has a longitudinal axis (L) to which it is axially symmetrical.

6. Magnetic field sensor (100) according to one of the preceding claims, **characterized in that** the surface (O) of the core (130) is curved in a transition region between the sections (M, E, A1, A2).

## Revendications

1. Détecteur (100) de champ magnétique présentant :
un noyau magnétisable (130),
un dispositif de magnétisation (110) qui magnétise le noyau (130) et
un dispositif de détermination (120) qui détermine le champ magnétique qui règne dans le noyau (130),
le noyau (130) présentant une surface (O) dont au moins certaines parties sont cintrées,
caractérisé en de que
le noyau présente deux extrémités et
en ce que le noyau se rétrécit dans une partie centrale (M, Q) située entre les extrémités.

2. Détecteur (100) de champ magnétique selon la revendication 1, **caractérisé en ce que** la coupe longitudinale (320,350) du noyau présente des extrémités dont les sections d'extrémité (E) sont épaissies.

3. Détecteur (100) de champ magnétique selon les revendications 1 ou 2, **caractérisé en ce que** la coupe longitudinale (350) du noyau présente un fort rétrécissement dans sa partie centrale (M).

4. Détecteur (100) de champ magnétique selon la revendication 1, **caractérisé en ce que** la coupe longitudinale (360) du noyau présente une partie centrale (M) segmentée, **en ce que** dans la segmentation, des segments d'une première largeur (A1) alternent dans la direction horizontale avec des segments d'une deuxième largeur (A2) et **en ce que** les segments de la première largeur (A1) présentent un rétrécissement.

5. Détecteur (100) de champ magnétique selon l'une des revendications 1 à 4, **caractérisé en ce que** le noyau (130) présente un axe longitudinal (L) par rapport auquel il présente une symétrie axiale.

6. Détecteur (100) de champ magnétique selon l'une des revendications précédentes, **caractérisé en ce que** la surface (O) du noyau (130) est cintrée dans une partie de transition entre les parties (M, E, A1, A2).
